(19) Europäisches Patentamt
European Patent Office
Office européen des brevets

(11) Publication number: **0 068 808**
**B1**

(12) # EUROPEAN PATENT SPECIFICATION

(45) Date of publication of patent specification: **05.06.85**

(21) Application number: **82303276.8**

(22) Date of filing: **23.06.82**

(51) Int. Cl.$^4$: **G 03 F 7/26,** C 07 C 97/10, C 08 L 9/00, C 08 F 36/04, C 08 F 136/04, C 08 F 236/04, C 08 K 5/18, G 03 C 1/71, G 03 C 1/60 // H01L21/312, H01L21/47, H05K3/06

(54) **Photoresist composition.**

(30) Priority: **23.06.81 JP 96963/81**

(43) Date of publication of application:
**05.01.83 Bulletin 83/01**

(45) Publication of the grant of the patent:
**05.06.85 Bulletin 85/23**

(84) Designated Contracting States:
**DE FR GB**

(56) References cited:
**EP-A-0 028 486**
**DE-A-3 106 878**
**GB-A- 943 266**
**CHEMICAL ABSTRACT, vol. 48, no. 20, October 25, 1954, Columbus, Ohio, USA F.C. COPP "Diacid Bases. I. Compounds related to 1,5-diphenyl-pentane-p,p'-bis(trialkylammonium) salts as anticholinesterases" column 12 051g**

**CHEMICAL ABSTRACT, vol. 60, no. 9, April 27, 1964, Columbus, Ohio, USA NGUYEN P. BUU-HOI et al. "Condensation products of cyclic ketones with aromatic amine aldehydes and their choleretic activity" column 10 589g**

(73) Proprietor: **JAPAN SYNTHETIC RUBBER CO., LTD.**
**11-24, Tsukiji-2-chome Chuo-ku**
**Tokyo (JP)**

(72) Inventor: **Kamoshida, Youichi**
**29, Aobadai-2-chome**
**Midori-ku Yokohama (JP)**
Inventor: **Yoshihara, Toshiaki**
**29, Aobadai-2-chome**
**Midori-ku Yokohama (JP)**
Inventor: **Harita, Yoshiyuki**
**9-6, Shirohatadai-1-chome**
**Takatsu-ku Kawsaki-shi (JP)**
Inventor: **Harada, Kunihiro**
**2657-6, Naruse**
**Machida-shi (JP)**

(74) Representative: **Tubby, David George et al**
**MARKS & CLERK 57-60 Lincoln's Inn Fields**
**London WC2A 3LS (GB)**

**EP 0 068 808 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to a photoresist composition of the type comprising a cyclized product of a conjugated diene polymer (which may be a homopolymer or copolymer) and a photo-crosslinking agent soluble in organic solvents.

Progress in the techniques for producing integrated circuits is so rapid that the degree of integration has, in recent years, increased at the rate of about 2 times per year. As a result, improvements are not only needed in production techniques but also in the apparatus used and in auxiliary materials. Photoresist compositions, which are amongst the materials used in the production of integrated circuits, are particularly required to be easy to handle and have a high degree of resolution. At present, in the production of integrated circuits, a composition comprising a diazide compound and a cyclized polyisoprene is used for negative-type photoresist compositions, whilst a composition comprising a quinonediazide compound and a novolac resin is used as a positive-type photoresist composition. Although the former composition has excellent handling qualities, it has a low degree of resolution, particularly when the base board or substrate has a surface of high reflectance (i.e. a reflectance of 80% or more, especially 90% or more, against light of wavelength from 350 to 450 μm). Although the latter composition has an excellent degree of resolution, it has inferior handling qualities.

Thus, if a photoresist composition comprising a diazide compound and cyclized polyisoprene is used on a base board of high reflectance, e.g. aluminium or chromium, the radiation to which the composition is exposed to effect crosslinking is reflected by the surface of the base board into regions which are not intended to be exposed to light (this phenomenon is called "halation") and, as a result, these regions are exposed and crosslinked. This phenomenon is particularly marked when the base board is stepped and exposed parts called "spikes" are formed, thus reducing the degree of resolution.

The phenomenon of halation is illustrated by the accompanying drawing, which shows a cross-section of a photoresist structure. In the drawing, there is shown a mask 1 having a light-shading part 23 and a light-transmitting part 3, through which incident light 4 passes. The light passes through and crosslinks a photoresist composition 6 and reaches a slant 7 in the stepped structure of a base board 8. This slant 7 reflects the light 5, which, as a result, passes under the light-shading part 2 of the mask, thus exposing this part of the photoresist composition also to light. As a result, a part of the photoresist composition which is not intended to be exposed to light becomes exposed, thus reducing the degree of resolution.

A method of overcoming this problem is disclosed in Japanese Patent Publication No. 37562/76 by adding a light-absorbing material to the photoresist composition to decrease the light transmittance of the coating film of the photoresist composition. Thus, any light reflected by the surface of the base board is absorbed by the light-absorbing material and rapidly attenuates, so that the amount of light passing into regions which are not intended to be exposed to light can be much reduced and the degree of resolution correspondingly increased.

However, photoresist compositions, once applied to the base board must be subjected to "prebaking", generally at a temperature of from 80 to 100°C, in order to eliminate residual solvent. However, at this temperature, the light-absorbing materials proposed, such as oil-soluble dye Oil Yellow (a trade name for *p*-diethylaminoazobenzene) are lost by vaporization from the photoresist composition film; as a result, the amount of anti-halation agent in the composition may become insufficient and, in any case, the amount remaining is so greatly affected by the prebaking treatment as to give very poor reproducibility.

We have now discovered a photoresist composition which is capable of giving an image having a high degree of resolution with excellent reproducibility which is not affected by the prebaking conditions. This is achieved by adding a specific type of compound to a photoresist composition comprising a cyclized product of a conjugated diene polymer and a photo-crosslinking agent soluble in an organic solvent. The high degree of resolution can be achieved even if a base board having a highly reflecting surface is used.

Thus, the present invention consists in a photoresist composition comprising a cyclized product of a conjugated diene polymer, a photo-crosslinking agent soluble in an organic solvent and an anti-halation agent, characterized in that the anti-halation agent is at least one compound of formula (I) or (II):

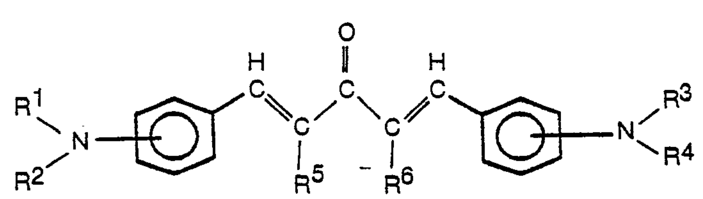
(I)

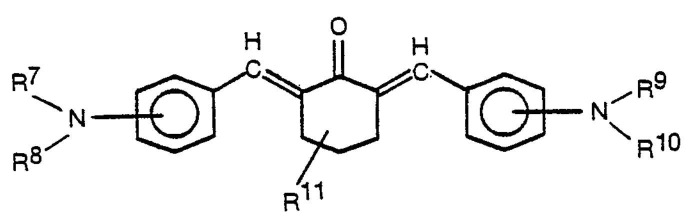
(II)

in which $R^1$, $R^2$, $R^3$, $R^4$, $R^5$, $R^6$, $R^7$, $R^8$, $R^9$, $R^{10}$ and $R^{11}$ which may be the same or different, each represents a hydrogen atom or an alkyl group.

The conjugated diene polymer, whose cyclized product is employed in the composition of the invention, may be a homopolymer or copolymer and is preferably such a polymer having at least one of the following units in the polymer chain:

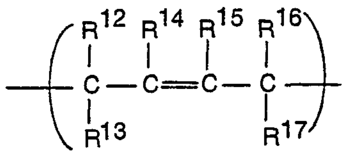
and
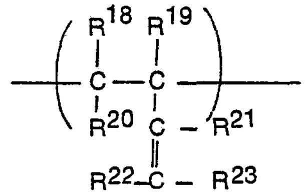

in which $R^{12}$, $R^{13}$, $R^{14}$, $R^{15}$, $R^{16}$, $R^{17}$, $R^{18}$, $R^{19}$, $R^{20}$, $R^{21}$, $R^{22}$ and $R^{23}$, which may be the same or different, each represents a hydrogen atom, an alkyl group (preferably a lower alkyl group such a methyl, ethyl or propyl) or an aryl group.

Specific examples of such cyclized products include cyclized products of homopolymers comprising *cis*-1,4-butadiene units, *trans*-1,4-butadiene units, *cis*-1,4-isoprene units, *trans*-1,4-isoprene units, *cis*-1,4-pentadiene units, *trans*-1,4-pentadiene units, 2-phenylbuta-1,4-diene units, 1,2-butadiene units, 3,4-isoprene units, 1,2-pentadiene units or 2-phenylbuta-3,4-diene units, and cyclized products of copolymers having one or more of these conjugated diene units together with units derived from an unsaturated copolymerizable monomer, for example an alkenyl-aromatic compound (for example styrene or α-methylstyrene) or an olefin (for example ethylene, propylene or isobutylene). Of course, a cyclized product of natural rubber can also be used.

We prefer to use cyclized products of homopolymers or copolymers having *cis*-1,4-isoprene units, *trans*-1,4-isoprene units, 3,4-isoprene units, *cis*-1,4-butadiene units, *trans*-1,4-butadiene units or 1,2-butadiene units, of which cyclized products of isoprene homopolymers or butadiene homopolymers are particularly preferred.

The amount of residual double bonds in the cyclized product of the conjugated diene polymer is not critical, although it is preferably from 5 to 95%, more preferably from 10 to 90% and most preferably from 15 to 50%, and is determined as the proportion of hydrogen atoms combined with unsaturated carbon to the total hydrogen atoms of the cyclized product of the conjugated diene polymer divided by the proportion of hydrogen atoms combined with unsaturated carbon to the total hydrogen atoms of the raw diene polymer, expressed as a percentage; the individual proportions can be determined by nuclear magnetic resonance spectroscopy.

The preferred photo-crosslinking agents soluble in organic solvents which are employed in the composition of the invention are azide-type photosensitive materials, for example 4,4'-diazidostilbene, *p*-phenylene bisazide, 4,4'-diazidobenzophenone, 4,4'-diazidodiphenylmethane, 4,4'-diazidochalcone, 2,6-bis(4'-azidobenzylidene)cyclohexanone, 2,6-bis(4'-azidobenzylidene)-4-methylcyclohexanone, 4,4'-diazidobiphenyl, 4,4'-diazido-3,3'-dimethylbiphenyl and 2,7-diazidofluorene, but the present invention is not limited to the use of this type of photo-crosslinking agent and any such agent may be used, provided that it is effective when combined with the cyclized product of the conjugated diene polymer also used in this invention. All of these photo-crosslinking agents are preferably used in an amount of from 0.1 to 10 parts by weight, more preferably from 1 to 5 parts by weight per 100 parts by weight of the cyclized product of the conjugated diene polymer.

In the compounds of formulae (I) and (II), which are added to the composition of the invention as the anti-halation agent, the symbols $R^1$ to $R^{11}$ preferably represent hydrogen atoms or alkyl groups having from 1 to 4 carbon atoms. Examples of such compounds include 2,6-bis(4-dimethylaminobenzylidene)cyclohexanone, 2,6-bis(4-dimethylaminobenzylidene)-4-methylcyclohexanone, 2,6-bis(4-diethylaminobenzylidene)cyclohexanone, 2,6-bis(4-diethylaminobenzylidene)-4-methylcyclohexanone, 2,6-bis(4-dipropylaminobenzylidene)cyclohexanone, 2,6-bis(4-dipropylaminobenzylidene)-4-methylcyclohexanone, 2,6-bis(4-dimethylaminobenzylidene)-4-ethylcyclohexanone, 2,6-bis(4-diethylaminobenzylidene)-4-ethylcyclohexanone, 2,6-bis(4-dipropylaminobenzylidene)-4-ethylcyclohexanone, 2,6-bis(4-dimethylaminobenzylidene)-4-propylcyclohexanone, 2,6-bis(4-diethylaminobenzylidene)-4-propylcyclohexanone, 2,6-bis(4-dipropylaminobenzylidene)-4-propylcyclohexanone, 2,6-bis(4-aminobenzylidene)cyclohexanone, 2,6-bis(4-aminobenzylidene)-4-methylcyclohexanone, 2,6-bis(4-aminobenzylidene)-4-ethylcyclohexanone, 2,6-bis(4-aminobenzylidene)-4-propylcyclohexanone, 2,6-bis(4-dibutylaminobenzylidene)cyclohexanone, 1,5-bis(4-aminophenyl)penta-1,4-dien-3-one, 1,5-bis(4-dimethylaminophenyl)penta-1,4-dien-3-one, 1,5-bis(4-diethylaminophenyl)penta-1,4-dien-3-one, 1,5-bis(4-dipropylaminophenyl)penta-1,4-dien-3-one, 1,5-bis(4-aminophenyl)-2,4-dimethylpenta-1,4-dien-3-one, 1,5-bis(4-dimethylaminophenyl)-2,4-dimethylpenta-1,4-dien-3-one, 1,5-bis(4-diethylaminophenyl)-2,4-dimethylpenta-1,4-dien-3-one, 1,5-bis(4-dipropylaminophenyl)-2,4-dimethylpenta-1,4-dien-3-one, 2,6-bis(3-diethylaminobenzylidene)cyclohexanone, 2,6-bis(3-diethylaminobenzylidene)-4-methylcyclohexanone, 2,6-bis(3-diethylaminobenzylidene)-4-ethylcyclohexanone, 1,5-bis(3-diethylaminophenyl)penta-1,4-dien-3-one, 1,5-bis(3-diethylaminophenyl)-2,4-dimethylpenta-1,4-dien-3-one and 1,5-bis(3-dibutylaminophenyl)-2,4-dimethylpenta-1,4-dien-3-one.

These compounds are preferably added in an amount of from 0.1 to 10 parts by weight, more preferably from 1 to 5 parts by weight, per 100 parts by weight of the cyclized product of the conjugated diene polymer. In general, it is undesirable to add an amount less than 0.1 part by weight, since the addition of too little of the compound will have little effect; on the other hand, if the amount added is greater than 10 parts by weight, in some cases, the yield of the residual resist thickness may be too small.

It is also possible to incorporate a sensitizer into the photoresist composition of the present invention. Suitable sensitizers include, for example: carbonyl compounds, such as benzophenone, anthraquinone, 1,2-naphthoquinone, 1,4-naphthoquinone, 2-methylanthraquinone, benzanthrone, violanthrone, 9-anthraldehyde, benzil, *p,p'*-tetramethyldiaminobenzophenone or chloranil; aromatic hydrocarbons, such as anthracene or chrysene; nitro compounds, such as nitrobenzene, *p*-dinitrobenzene, 1-nitronaphthalene, *p*-nitrobiphenyl, 2-nitronaphthalene, 2-nitrofluorene or 5-nitroacenaphthene; nitrogen compounds, such as nitroaniline, 2-chloro-4-nitroaniline, 2,6-dichloro-4-nitroaniline, 5-nitro-2-aminotoluene or tetracyanoethylene; and sulphur compounds, such as diphenyl disulphide.

If necessary, a storage stabiliser may also be added and examples of such compounds include: hydroxyaromatic compounds, such as hydroquinone, methoxyphenol or *p*-t-butylcatechol; quinone compounds, such as benzoquinone, *p*-toluquinone or *p*-xyloquinone; amine compounds, such as phenyl- and -naphthylamine or *p,p'*-diphenylphenylenediamine; and sulphur compounds, such as dilauryl thiodipropionate, 4,4'-thiobis(6-t-butyl-3-methylphenol), 2,2'-thiobis(6-t-butyl-4-methylphenol) and 2-(3,5-di-t-butyl-4-hydroxyanilino)-4,6-bis(n-octylthio)-*s*-triazine.

Using the photoresist composition of the present invention, the decrease in degree of resolution due to halation can be prevented even on a highly reflecting base board having a step structure, with a high reproducibility, which is not affected by prebaking conditions. Furthermore, there is no decrease in the adhesiveness between the photoresist composition of the present invention and a silicon oxide film. Thus, the present invention markedly reduces sensitivity to prebaking conditions and the decrease in adhesion, both of which are unavoidable when using conventional anti-halation techniques.

The invention is further illustrated by the following Examples.

## Example 1

(a) Preparation of 1,5-bis(4-diethylaminophenyl)penta-1,4-dien-3-one

17.7 g of *p*-diethylaminobenzaldehyde and 2.9 g of acetone were dissolved in 25 ml of anhydrous ethanol; 1.5 ml of a 10% w/w aqueous solution of sodium hydroxide was then added dropwise to the resulting solution, after which the mixture was allowed to react under reflux for 8 hours. The reaction mixture was then cooled and the crystals which precipitated were collected by filtration and then recrystallised from toluene, to give 7.7 g of the desired 1,5-bis(4-diethylaminophenyl)penta-1,4-dien-3-one, melting at 168°C.

(b) Preparation of photoresist composition

A photoresist composition was prepared by adding to 11.00 g of a cyclized product of *cis*-1,4-polyisoprene (having a residual double bond content of 26%, $[\eta]^{30°C}_{xylene} = 0.72$) 0.22 g of 2,6-bis(4-azidobenzylidene)cyclohexanone (a photo-crosslinking agent), 0.11 g of 2,2'-methylenebis(6-t-butyl-4-methylphenol) and 0.11 g of 4,4'-thiobis(2,6-di-t-butylphenol) (both storage stabilizers); to this were added, in the amounts shown in Table 1, the 1,5-bis(4-diethylaminophenyl)penta-1,4-diene-3-one prepared as in step (a) and xylene.

(c) Preparation and testing of photoresist

The photoresist composition prepared in step (b) was applied, with rotation by means of a spinner, to a final thickness of 1.0 μm to a silicon wafer having a 0.6 μm step structure and having an aluminium layer of thickness 0.2 μm vacuum-deposited thereon. The coated silicon wafer was then dried in a circulation-type thermostatic chamber at 95°C for 30 minutes. It was then exposed to the radiation from an ultra high pressure mercury lamp at a light intensity of 50 W/m$^2$ through a resolution test chart chromium mask to form a latent image. The exposed wafer was then subjected to immersion development with a Kodak Microresist Developer (manufactured by Eastman Kodak) and then rinsed for 1 minute with butyl acetate. The developed image was observed and the yield of the residual resist thickness was 90% or more in every case.

The results obtained are shown in Table 1, in which the length of the exposed region is the value obtained by measuring the length of the region exposed to light 5 from the slant 7, as shown in the accompanying drawing.

In Table 1, and hereinafter, the "degree of resolution" is the degree of resolution in the flat part and the "length of exposed region" is the length of the region exposed to light which hadbeen reflected by the step structure and transmitted into the masked region.

TABLE 1

| | Run No. | Amount of 1,5-bis-(4-diethylaminophenyl)-penta-1,4-dien-3-one (g) | Amount of xylene added (g) | Exposure time (sec) | Degree of resolution (μm) | Length of exposed region (μm) |
|---|---|---|---|---|---|---|
| Example 1 | 1 | 0.33 | 88.2 | 3.0 | 2.0 | 1 |
| | 2 | 0.33 | 88.2 | 4.0 | 2.0 | 1–2 |
| | 3 | 0.55 | 88.0 | 5.0 | 1.8 | <1 |
| | 4 | 0.55 | 88.0 | 6.0 | 1.8 | <1 |

Example 2

In Runs No. 5—8, a latent image was formed and developed as described in Example 1(c) (Runs No. 1—4), using the same photoresist composition as in Example 1 and a silicon wafer overlaid with a thermally oxidized silicon film having a thickness of 0.7 μm instead of the vacuum-deposited aluminium layer. The resulting photoresist was then heat-treated in a nitrogen atmosphere for 30 minutes at 150°C, after which it was etched for 30 minutes at 25°C with an etchant comprising a mixture of a 49% w/w aqueous solution of hydrogen fluoride, a 40% w/w aqueous solution of ammonium fluoride and water in a volume ratio of 1:6:10. The depth of side etching (a phenomenon in which the edges of the photoresist composition are undercut by the etchant coming round into them) was 2.2 μm in each of Runs No. 5—8. This proves that the adhesion between the film of the photoresist composition of the present invention and the silicon wafer is superior to that achieved when using conventional photoresist compositions, for example as typified by Comparative Example 3 hereinafter.

Example 3

(a) Preparation of 2,6-bis(4-diethylaminobenzylidene)-4-methylcyclohexanone

35.4 g of *p*-diethylaminobenzaldehyde and 11.2 g of 4-methylcyclohexanone were dissolved in 50 ml of anhydrous ethanol, and then 20 ml of a 10% w/w ethanolic solution of sodium ethoxide were added dropwise to the resulting solution. The mixture was then allowed to react under reflux for 5 hours. At the end of this time, the reaction mixture was cooled and the crystals which precipitated were collected by filtration and then recrystallised from toluene, to give 30.2 g of the desired 2,6-bis(4-diethylamino-benzylidene)-4-methylcyclohexanone, melting at 169°C.

(b) Preparation and testing of photoresist composition and photoresist

A photoresist composition was prepared as described in Example 1(b), except that the 1,5-bis(4-diethylaminophenyl)penta-1,4-dien-3-one was replaced by the 2,6-bis(4-diethylaminobenzylidene)-4-methylcyclohexanone prepared in step (a) above.

Using this photoresist composition, and a silicon wafer having a vacuum-deposited layer of aluminium, a latent image was formed and developed exactly as described in Example 1(c). The yield of the residual resist thickness on the image obtained was 90% or more in all cases. The results are shown in Table 2.

TABLE 2

| | Run No. | Amount of 2,6-bis(4-diethylamino-benzylidene)-4-methylcyclo-hexanone added (g) | Amount of xylene added (g) | Exposure time (sec) | Degree of resolution (μm) | Length of exposed region (μm) |
|---|---|---|---|---|---|---|
| Example 3 | 9 | 0.33 | 88.2 | 3.0 | 2.2 | 1 |
| | 10 | 0.33 | 88.2 | 4.0 | 2.0 | 1–2 |
| | 11 | 0.66 | 87.8 | 5.0 | 1.7 | <1 |
| | 12 | 0.66 | 87.8 | 6.0 | 1.7 | <1 |

Example 4

In Runs No. 13—16, a latent image was formed and developed as described in Example 3, Runs No. 9—12, using the same photoresist composition as in Example 3, but with a silicon wafer overlaid with a thermally oxidized silicon film having a thickness of 0.7 μm in place of the vacuum-deposited aluminium layer. The resulting photoresist was then heat-treated for 30 minutes in a nitrogen atmosphere at 150°C and etched at 25°C for 30 minutes with the etchant described in Example 2. The depth of side etching was 2.2 μm in each of Runs No. 13—16. This demonstrates that the adhesion between the film of the photoresist composition of the invention and the silicon wafer is superior to that of conventional compositions, as typified by Comparative Example 3, hereafter.

Example 5

(a) Preparation of 2,6-bis(4-diethylaminobenzylidene)-4-ethylcyclohexanone

35.4 g of *p*-diethylaminobenzaldehyde and 12.6 g of 4-ethylcyclohexanone were dissolved in 50 ml of anhydrous ethanol; 20 ml of a 10% w/w ethanolic solution of sodium ethoxide were then added dropwise to the resulting solution and this mixture was allowed to react, under reflux, for 12 hours. At the end of this time, the reaction mixture was cooled and the crystals which precipitated were collected by filtration and then recrystallised from toluene, to give 15.8 g of the desired 2,6-bis(4-diethylamino-benzylidene)-4-ethylcyclohexanone, melting at 141°C.

(b) Preparation and testing of photoresist composition and photoresist

A photoresist composition was then prepared as described in Example 1(b), except that the 1,5-bis(4-diethylaminophenyl)penta-1,4-dien-3-one was replaced by the 2,6-bis(4-diethylaminobenzylidene)-4-ethylcyclohexanone prepared as in step (a) above.

Using this photoresist composition, a latent image was formed and developed as described in Example 1 on a silicon wafer having a vacuum-deposited aluminium layer. The yield of residual resist thickness on the image obtained was 90% or more in each case. The results are shown in Table 3.

Furthermore, the adhesion between the photoresist film and a silicon wafer having a surface film of thermally oxidized silicon was evaluated as described in Example 2, giving results comparable with those achieved in Example 2.

TABLE 3

| | Run No. | Amount of 2,6-bis(4-diethylamino-benzylidene)-4-ethyl cyclohexanone added (g) | Amount of xylene added (g) | Exposure time (sec) | Degree of resolution (μm) | Length of exposed region (μm) |
|---|---|---|---|---|---|---|
| Example 5 | 17 | 0.33 | 88.2 | 3.0 | 2.2 | 1 |
| | 18 | 0.33 | 88.2 | 4.0 | 2.0 | 1–2 |
| | 19 | 0.66 | 87.8 | 5.0 | 1.7 | <1 |
| | 20 | 0.66 | 87.8 | 6.0 | 1.7 | <1 |

Example 6

(a) Preparation of 2,6-bis(4-diethylaminobenzylidene)cyclohexanone

17.7 g of *p*-diethylaminobenzaldehyde and 4.9 g of cyclohexanone were dissolved in 25 ml of anhydrous ethanol; 10 ml of a 10% w/w ethanolic solution of sodium ethoxide were then added dropwise to the resulting solution, after which the mixture was allowed to react, under reflux, for 12 hours. The reaction mixture was then cooled and the crystals which precipitated were collected by filtration and recrystallised from toluene, giving 12.8 g of 2,6-bis(4-diethylaminobenzylidene)cyclohexanone, melting at 167°C.

(b) Preparation and testing of photoresist composition and photoresist

A photoresist composition was prepared as described in Example 1(b), except that the 1,5-bis(4-diethylaminophenyl)penta-1,4-dien-3-one was replaced by 2,6-bis(4-diethylaminobenzylidene)-cyclohexanone, prepared as described in step (a) above.

Using the photoresist composition thus prepared, a latent image was formed and developed as described in Example 1(c) on a silicon wafer having a vacuum-deposited aluminium layer. The yield of residual resist thickness on the image obtained was 90% or more in all cases. The results are shown in Table 4.

Furthermore, the adhesion between the photoresist film and a silicon wafer having a thermally oxidized silicon film was evaluated as described in Example 2, giving results as good as those achieved in Example 2.

TABLE 4

| | Run No. | Amount of 2,6-bis(4-diethylamino-benzylidene)-cyclohexanone added (g) | Amount of xylene added (g) | Exposure time (sec) | Degree of resolution (μm) | Length of exposed region (μm) |
|---|---|---|---|---|---|---|
| Example 6 | 21 | 0.22 | 88.3 | 3.0 | 2.2 | 1–2 |
| | 22 | 0.22 | 88.3 | 4.0 | 2.0 | 1–2 |

Example 7

2,6-Bis(4-dimethylaminobenzylidene)-4-methylcyclohexanone was prepared by following the procedure described in Example 6 but replacing the *p*-diethylaminobenzaldehyde by *p*-dimethylaminobenzaldehyde. 0.22 g of this 2,6-bis(4-dimethylaminobenzylidene)-4-methylcyclohexanone was then used to prepare a photoresist composition and a photoresist, as described in Example 6, and this was tested as in Example 6, giving equally good results both when using a silicon wafer having a vacuum-deposited aluminium layer and a silicon wafer having a thermally oxidized silicon film.

Comparative Example 1

The same photoresist composition as is described in Example 1 was prepared, except that the anti-halation agent was omitted. This photoresist composition was coated onto a silicon wafer having a vacuum-deposited aluminium layer, as in Example 1, and exposed to light for 3.0 seconds to form a latent image, which was then developed as in Example 1. As a result, the degree of resolution in the flat parts of the photoresist was 2.9 µm, but the length of the region exposed to light which had been reflected by the step structure and gone round underneath the part shaded from light reached 7 µm or even more.

Comparative Example 2

A photoresist composition was prepared by adding 0.55 g of Oil Yellow as an anti-halation agent to the same photoresist composition as was prepared in Comparative Example 1. Using this photoresist composition, a latent image was formed and developed in the same way as in Example 1. The results are shown in Table 5.

TABLE 5

| | Exposure time (sec) | Degree of resolution (µm) | Length of exposed region (µm) |
|---|---|---|---|
| Comparative | 3.0 | 2.6 | 5 |
| Example 2 | 4.0 | 2.9 | 5 |

Comparative Example 3

Using the same photoresist composition as in Comparative Example 2, a latent image was formed and developed as in Comparative Example 2, except that the silicon wafer was coated with a thermally oxidized silicon film having a thickness of 0.7 µm in place of the vacuum-deposited aluminium layer. This photoresist was heat-treated for 30 minutes in a nitrogen atmosphere at 150°C and then etched at 25°C for 30 minutes with the etchant described in Example 2. The depth of side etching was 5.0 µm.

**Claims**

1. A photoresist composition comprising a cyclized product of a conjugated diene polymer, a photo-crosslinking agent soluble in an organic solvent and an anti-halation agent, characterized in that the anti-halation agent is at least one compound of formula (I) or (II):

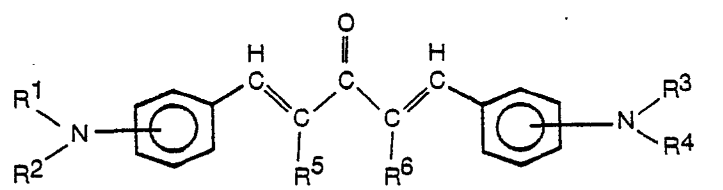

(I)

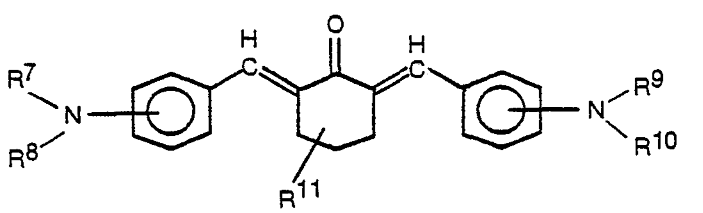

(II)

in which $R^1$, $R^2$, $R^3$, $R^4$, $R^5$, $R^6$, $R^7$, $R^8$, $R^9$, $R^{10}$ and $R^{11}$ are the same or different and each represents a hydrogen atom or an alkyl group.

2. A composition according to Claim 1, in which said compound of formula (I) or (II) is present in an amount of from 0.1 to 10 parts by weight per 100 parts by weight of said cyclized product.

3. A composition according to Claim 2, in which said compound of formula (I) or (II) is present in an amount of from 1 to 5 parts by weight per 100 parts by weight of said cyclized product.

4. A composition according to any one of the preceding claims, in which each of $R^1$, $R^2$, $R^3$, $R^4$, $R^5$, $R^6$, $R^7$, $R^8$, $R^9$, $R^{10}$ and $R^{11}$ represents a hydrogen atom or an alkyl group having from 1 to 4 carbon atoms.

5. A composition according to Claim 4, in which said compound of formula (I) or (II) is at least one of the compounds: 2,6-bis(4-dimethylaminobenzylidene)cyclohexanone, 2,6-bis(4-dimethylaminobenzylidene)-4-methylcyclohexanone, 2,6-bis(4-diethylaminobenzylidene)cyclohexanone, 2,6-bis(4-diethylaminobenzylidene)-4-methylcyclohexanone, 2,6-bis(4-dipropylaminobenzylidene)cyclohexanone, 2,6-bis(4-dipropylaminobenzylidene)-4-methylcyclohexanone, 2,6-bis(4-dimethylaminobenzylidene)-4-ethylcyclohexanone, 2,6-bis(4-diethylaminobenzylidene)-4-ethylcyclohexanone, 2,6-bis(4-dipropylaminobenzylidene)-4-ethylcyclohexanone, 2,6-bis(4-dimethylaminobenzylidene)-4-propylcyclohexanone, 2,6-bis(4-diethylaminobenzylidene)-4-propylcyclohexanone, 2,6-bis(4-dipropylaminobenzylidene)-4-propylcyclohexanone, 2,6-bis(4-aminobenzylidene)cyclohexanone, 2,6-bis(4-aminobenzylidene)-4-methylcyclohexanone, 2,6-bis(4-aminobenzylidene)-4-ethylcyclohexanone, 2,6-bis(4-aminobenzylidene)-4-propylcyclohexanone, 2,6-bis(4-dibutylaminobenzylidene)cyclohexanone, 1,5-bis(4-aminophenyl)penta-1,4-dien-3-one, 1,5-bis(4-dimethylaminophenyl)penta-1,4-dien-3-one, 1,5-bis(4-diethylaminophenyl)penta-1,4-dien-3-one, 1,5-bis(4-dipropylaminophenyl)penta-1,4-dien-3-one, 1,5-bis(4-aminophenyl)-2,4-dimethylpenta-1,4-dien-3-one, 1,5-bis(4-dimethylaminophenyl)-2,4-dimethylpenta-1,4-dien-3-one, 1,5-bis(4-diethylaminophenyl)-2,4-dimethylpenta-1,4-dien-3-one, 1,5-bis(4-dipropylaminophenyl)-2,4-dimethylpenta-1,4-dien-3-one, 2,6-bis(3-diethylaminobenzylidene)cyclohexanone, 2,6-bis(3-diethylaminobenzylidene)-4-methylcyclohexanone, 2,6-bis(3-diethylaminobenzylidene)-4-ethylcyclohexanone, 1,5-bis(3-diethylaminophenyl)penta-1,4-dien-3-one, 1,5-bis(3-diethylaminophenyl)-2,4-dimethylpenta-1,4-dien-3-one and 1,5-bis(3-dibutylaminophenyl)-2,4-dimethylpenta-1,4-dien-3-one.

6. A composition according to any one of the preceding claims, in which said conjugated diene polymer from which the cyclized product is prepared has, in its polymer chain, a unit of formula:

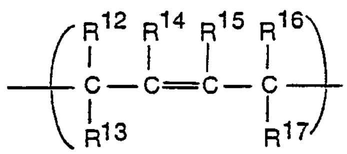

or

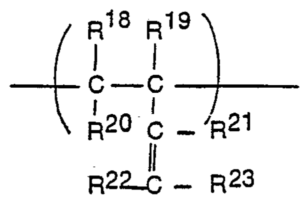

in which $R^{12}$, $R^{13}$, $R^{14}$, $R^{15}$, $R^{16}$, $R^{17}$, $R^{18}$, $R^{19}$, $R^{20}$, $R^{21}$, $R^{22}$ and $R^{23}$ are the same or different and each represents a hydrogen atom, an alkyl group or an aryl group.

7. A composition according to Claim 6, in which said unit is a *cis*-1,4-butadiene unit, a *trans*-1,4-butadiene unit, a *cis*-1,4-isoprene unit, a *trans*-1,4-isoprene unit, a *cis*-1,4-pentadiene unit, a *trans*-1,4-pentadiene unit, a 2-phenylbuta-1,4-diene unit, a 1,2-butadiene unit, a 3,4-isoprene unit, a 1,2-pentadiene unit or a 2-phenylbuta-3,4-diene unit.

8. A composition according to any one of the preceding claims, in which said photo-crosslinking agent is a photosensitive substrate of the azide type.

9. A composition according to Claim 8, in which said photosensitive substrate is 4,4'-diazidostilbène, *p*-phenylene bisazide, 4,4'-diazidobenzophenone, 4,4'-diazidophenylmethane, 4,4'-diazidochalcone, 2,6-bis(4-azidobenzylidene)-cyclohexanone, 2,6-bis(4-azidobenzylidene)-4-methylcyclohexanone, 4,4'-diazidobiphenyl, 4,4'-diazido-3,3'-dimethylbiphenyl or 2,7-diazidofluorene.

10. A composition according to any one of the preceding claims, in which the amount of residual double bonds in said cyclized product is from 5 to 95%.

11. A composition according to Claim 10, in which said amount of residual double bonds is from 15 to 50%.

12. A composition according to any one of the preceding claims, in which said cyclized product is a cyclized product of an isoprene homopolymer or of a butadiene homopolymer.

13. A composition according to any one of the preceding claims, in which said photo-crosslinking agent is employed in an amount of from 0.1 to 10 parts by weight per 100 parts by weight of said cyclized product.

14. A composition according to Claim 13, in which said photo-crosslinking agent is employed in an amount of from 1 to 5 parts by weight per 100 parts by weight of said cyclized product.

**Patentansprüche**

1. Photoresistzusammensetzung, ein cyclisiertes Pordukt eines konjugierten Dienpolymers, ein lichtempfindliches, in einem organischen Lösungsmittel lösliches Vernetzungsmittel und ein die Lichthofbildung verhinderndes Mittel enthaltend, dadurch gekennzeichnet, daß das die Lichthofbildung verhindernde Mittel mindestens eine Verbindung der Formel (I) oder (II) ist:

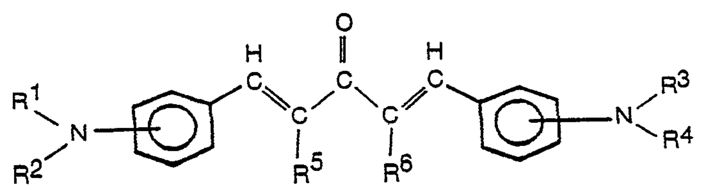

(I)

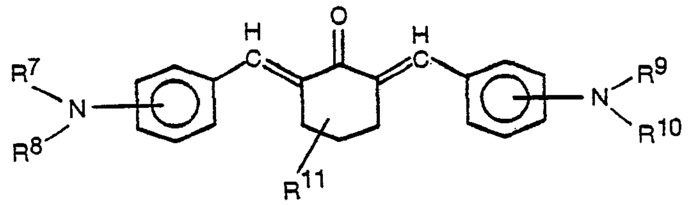

(II)

in denen $R^1$, $R^2$, $R^3$, $R^4$, $R^5$, $R^6$, $R^7$, $R^8$, $R^9$, $R^{10}$ und $R^{11}$ gleich oder verschieden sind und je ein Wasserstoffatom oder einen Alkylrest bedeuten.

2. Zusammensetzung nach Anspruch 1, dadurch gekennzeichnet, daß die Verbindung der Formel (I) oder (II) in einer Menge von 0,1 bis 10 Gewichtsteilen je 100 Gewichtsteile des cyclisierten Produkts vorhanden ist.

3. Zusammensetzung nach Anspruch 2, dadurch gekennzeichnet, daß die Verbindung der Formel (I) oder (II) in einer Menge von 1 bis 5 Gewichtsteilen je 100 Gewichtsteile des cyclisierten Produkts vorhanden ist.

4. Zusammensetzung nach einem der vorhergehenden Ansprüche, dadurch gekennzeichnet, daß $R^1$, $R^2$, $R^3$, $R^4$, $R^5$, $R^6$, $R^7$, $R^8$, $R^9$, $R^{10}$ und $R^{11}$ je ein Wasserstoffatom oder einen Alkylrest mit von 1 bis 4 Kohlenstoffatomen bedeuten.

5. Zusammensetzung nach Anspruch 4, dadurch gekennzeichnet, daß die Verbindung der Formel (I) oder (II) mindestens eine der folgenden Verbindungen ist: 2,6-Bis-(4-dimethylaminobenzyliden)-cyclohexanon, 2,6-Bis-(4-dimethylaminobenzyliden)-4-methylcyclohexanon, 2,6-Bis-(4-diethylaminobenzyliden)-cyclohexanon, 2,6-Bis-(4-diethylaminobenzyliden)-4-methylcyclohexanon, 2,6-Bis-(4-dipropylaminobenzyliden)-cyclohexanon, 2,6-Bis-(4-dipropylaminobenzyliden)-4-methylcyclohexanon, 2,6-Bis-(4-dimethylaminobenzyliden)-4-ethylcyclohexanon, 2,6-Bis-(4-diethylaminobenzyliden)-4-ethylcyclohexanon, 2,6-Bis-(4-dipropylaminobenzyliden)-4-ethylcyclohexanon, 2,6-Bis-(4-dimethylaminobenzyliden)-4-propylcyclohexanon, 2,6-Bis-(4-diethylaminobenzyliden)-4-propylcyclohexanon, 2,6-Bis-(4-dipropylaminobenzyliden)-4-propylcyclohexanon, 2,6-Bis-(4-aminobenzyliden)-cyclohexanon, 2,6-Bis-(4-aminobenzyliden)-4-methylcyclohexanon, 2,6-Bis-(4-aminobenzyliden)-4-ethylcyclohexanon, 2,6-Bis-(4-aminobenzyliden)-4-propylcyclohexanon, 2,6-Bis-(4-dibutylaminobenzyliden)-cyclohexanon, 1,5-Bis-(4-aminophenyl)-penta-1,4-dien-3-on, 1,5-Bis-(4-dimethylaminophenyl)-penta-1,4-dien-3-on, 1,5-Bis-(4-diethylaminophenyl)-penta-1,4-dien-3-on, 1,5-Bis-(4-dipropylaminophenyl)-penta-1,4-dien-3-on, 1,5-Bis-(4-aminophenyl)-2,4-dimethylpenta-1,4-dien-3-on, 1,5-Bis-(4-dimethylaminophenyl)-2,4-dimethylpenta-1,4-dien-3-on, 1,5-Bis-(4-diethylaminophenyl)-2,4-dimethylpenta-1,4-dien-3-on, 1,5-Bis-(4-dipropylaminophenyl)-2,4-dimethylpenta-1,4-dien-3-on, 2,6-Bis-(3-diethylaminobenzyliden)-cyclohexanon, 2,6-Bis(3-diethylaminobenzyliden)-4-methylcyclohexanon, 2,6-Bis(3-diethylaminobenzyliden)-4-ethylcyclohexanon, 1,5-Bis-(3-diethylaminophenyl)-penta-1,4-dien-3-on, 1,5-Bis-(3-diethylaminophenyl)-2,4-dimethylpenta-1,4-dien-3-on und 1,5-Bis-(3-dibutylaminophenyl)-2,4-dimethylpenta-1,4-dien-3-on.

6. Zusammensetzung nach einem der vorhergehenden Ansprüche, dadurch gekennzeichnet, daß das konjugierte Dienpolymer, aus dem das cyclisierte Produkt hergestellt worden ist, in der Polymerkette eine Einheit der Formel

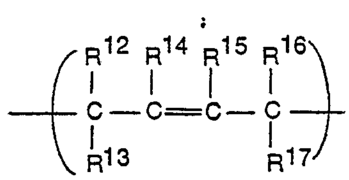

oder

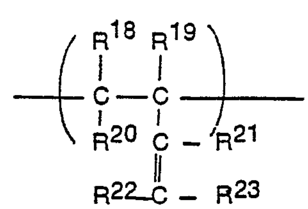

aufweist, in der $R^{12}$, $R^{13}$, $R^{14}$, $R^{15}$, $R^{16}$, $R^{17}$, $R^{18}$, $R^{19}$, $R^{20}$, $R^{21}$, $R^{22}$ und $R^{23}$ gleich oder verschieden sind und je ein Wasserstoffatom, einen Alkyl- oder Arylrest bedeuten.

7. Zusammensetzung nach Anspruch 6, dadurch gekennzeichnet, daß die Einheit eine cis-1,4-Butadien-, trans-1,4-Butadien-, cis-1,4-Isopren-, trans-1,4-Isopren-, cis-1,4-Pentadien-, trans-1,4-Pentadien-, 2-Phenylbuta-1,4-dien-, 1,2-Butadien-, 3,4-Isopren-, 1,2-Pentadien- oder 2-Phenylbuta-3,4-dien- Einheit ist.

8. Zusammensetzung nach einem der vorhergehenden Ansprüche, dadurch gekennzeichnet, daß das lichtempfindliche Vernetzungsmittel ein lichtempfindliches Azidderivat ist.

9. Zusammensetzung nach Anspruch 8, dadurch gekennzeichnet, daß die lichtempfindliche Verbindung 4,4'-Diazidostilben, p-Phenylen-bis-azid, 4,4'-Diazidobenzophenon, 4,4'-Diazidophenylmethan, 4,4'-Diazidochalcon, 2,6-Bis-(4-azidobenzyliden)-cyclohexanon, 2,6-Bis-(4-azidobenzyliden)-4-methylcyclohexanon, 4,4'-Diazidobiphenyl, 4,4'-Diazido-3,3'-dimethylbiphenyl oder 2,7-Diazidofluoren ist.

10. Zusammensetzung nach einem der vorhergehenden Ansprüche, dadurch gekennzeichnet, daß die restlichen Doppelbindungen im cyclisierten Produkt von 5 bis 95% ausmachen.

11. Zusammensetzung nach Anspruch 10, dadurch gekennzeichnet, daß die restlichen Doppelbindungen von 15 bis 50% ausmachen.

12. Zusammensetzung nach einem der vorhergehenden Ansprüche, dadurch gekennzeichnet, daß das cyclisierte Produkt das cyclisierte Produkt eines Isopren-Homopolymers oder eines Butadien-Homopolymers ist.

13. Zusammensetzung nach einem der vorhergehenden Ansprüche, dadurch gekennzeichnet, daß das lichtempfindliche Vernetzungsmittel in einer Menge von 0,1 bis 10 Gewichtsteilen je 100 Gewichtsteile des cyclisierten Produkts verwendet wird.

14. Zusammensetzung nach Anspruch 13, dadurch gekennzeichnet, daß das lichtempfindliche Vernetzungsmittel in einer Menge von 1 bis 5 Gewichtsteilen je 100 Gewichtsteile des cyclisierten Produkts verwendet wird.

**Revendications**

1. Composition de photorésist comprenant un produit cyclisé d'un polymère de diène conjugué, un agent de photo-réticulation soluble dans un solvant organique et un agent anti-halo, caractérisé en ce que l'agent anti-halo est au moins un composé répondant aux formules (I) ou (II):

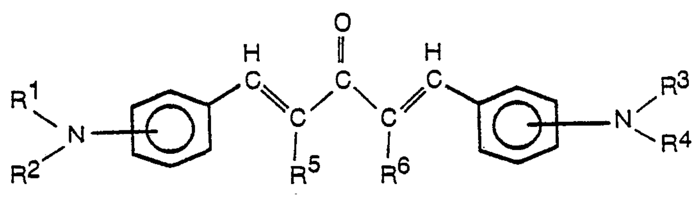

(I)

;

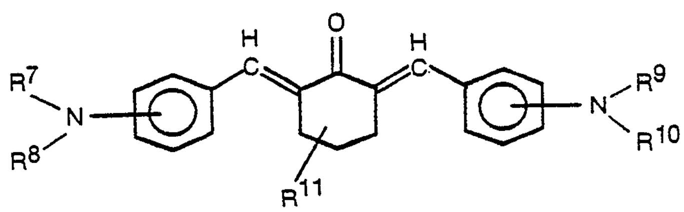

(II)

dans lesquelles $R^1$, $R^2$, $R^3$, $R^4$, $R^5$, $R^6$, $R^7$, $R^8$, $R^9$, $R^{10}$ et $R^{11}$ sont identiques ou différents et représentent chacun un atome d'hydrogène ou un groupe alkyle.

2. Composition suivant la revendication 1, dans laquelle le composé de formule (I) ou (II) est présent dans une proportion de 0,1 à 10 parties en poids pour 100 parties en poids de produit cyclisé.

3. Composition suivant la revendication 2, dans laquelle le composé de formule (I) ou (II) est présent dans une proportion de 1 à 5 parties en poids pour 100 parties en poids de produit cyclisé.

4. Composition suivant l'une quelconque des revendications précédentes, dans laquelle chacun des $R^1$, $R^2$, $R^3$, $R^4$, $R^5$, $R^6$, $R^7$, $R^8$, $R^9$, $R^{10}$ et $R^{11}$ représentent un atome d'hydrogène ou un groupe alkyle en $C_1$ à $C_4$.

5. Composition suivant la revendication 4, dans laquelle le composé de formule (I) ou (II) est au moins un des composés suivants: 2,6-bis(4-diméthylaminobenzylidène)cyclohexanone, 2,6-bis(4-diméthylaminobenzylidène)-4-méthylcyclohexanone, 2,6-bis(4-diéthylaminobenzylidène)cyclohexanone, 2,6-bis(4-diéthylaminobenzylidène)-4-méthylcyclohexanone, 2,6-bis(4-dipropylaminobenzylidène)cyclohexanone, 2,6-bis(4-dipropylaminobenzylidène)-4-méthylcyclohexanone, 2,6-bis(4-diméthylaminobenzylidène)-4-éthylcyclohexanone, 2,6-bis(4-diéthylaminobenzylidène)-4-éthylcyclohexanone, 2,6-bis(4-dipropylaminobenzylidène)-4-éthylcyclohexanone, 2,6-bis(4-diméthylaminobenzylidène)-4-propylcyclohexanone, 2,6-bis(4-diéthylaminobenzylidène)-4-propylcyclohexanone, 2,6-bis(4-dipropylaminobenzylidène)-4-propylcyclohexanone, 2,6-bis(4-aminobenzylidène)cyclohexanone, 2,6-bis(4-aminobenzylidène)-4-méthylcyclohexanone, 2,6-bis(4-aminobenzylidène)-4-éthylcyclohexanone, 2,6-bis(4-aminobenzylidène)-4-propylcyclohexanone, 2,6-bis(4-dibutylaminobenzylidène)cyclohexanone, 1,5-bis(4-aminophényl)penta-1,4-dièn-3-one, 1,5-bis(4-diméthylaminophényl)penta-1,4-dièn-3-one, 1,5-bis(4-diéthylaminophényl)penta-1,4-dien-3-one, 1,5-bis(4-dipropylaminophényl)penta-1,4-dièn-3-one, 1,5-bis(4-aminophényl)-2,4-diméthylpenta-1,4-dièn-3-one, 1,5-bis(4-diméthylaminophényl)-2,4-diméthylpenta-1,4-dièn-3-one, 1,5-bis(4-diéthylaminophényl)-2,4-diméthylpenta-1,4-dièn-3-one, 1,5-bis(4-dipropylaminophényl)-2,4-diméthylpenta-1,4-dièn-3-one, 2,6-bis(3-diéthylaminobenzylidène)cyclohexanone, 2,6-bis(3-diéthylaminobenzylidène)-4-méthylcyclohexanone, 2,6-bis(3-diéthylaminobenzylidène)-4-éthylcyclohexanone, 1,5-bis(3-diéthylaminophényl)penta-1,4-dién-3-one, 1,5-bis(3-diéthylaminophényl)-2,4-diméthylpenta-1,4-dièn-3-one et 1,5-bis(3-dibutylaminophényl)-2,4-diméthylpenta-1,4-dièn-3-one.

6. Composition suivant l'une quelconque des revendications précédentes, dans laquelle le polymère de diène conjugué à partir duquel le produit cyclisé est préparé a, dans sa chaîne polymère, un motif répondant à la formule:

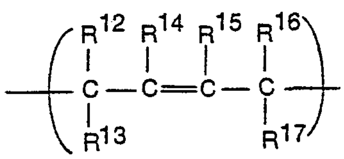

ou

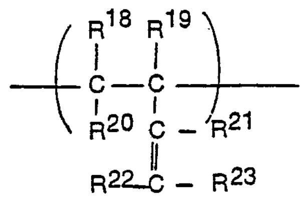

dans laquelle $R^{12}$, $R^{13}$, $R^{14}$, $R^{15}$, $R^{16}$, $R^{17}$, $R^{18}$, $R^{19}$, $R^{20}$, $R^{21}$, $R^{22}$ et $R^{23}$ sont identiques ou différents et représentent chacun un atome d'hydrogène, un groupe alkyle ou un groupe aryle.

7. Composition suivant la revendication 6, dans laquelle le motif est un motif *cis*-1,4-butadiène, un motif *trans*-1,4-butadiène, un motif *cis*-1,4-isoprène, un motif *trans*-1,4-isoprène, un motif *cis*-1,4-pentadiène, un motif *trans*-1,4-pentadiène, un motif 2-phénylbuta-1,4-diène, un motif 1,2-butadiène, un motif 3,4-isoprène, un motif 1,2-pentadiène ou un motif 2-phénylbuta-3,4-diène.

8. Composition suivant l'une quelconque des revendications précédentes, dans laquelle l'agent de photo réticulation est une substance photosensible du type azide.

9. Composition suivant la revendication 8, dans laquelle la substance photosensible est le 4,4'-diazidostilbène, le *p*-phénylène bisazide, la 4,4'-diazidobenzophénone, le 4,4-diazidophénylméthane, la 4,4'-diazidochalcone, la 2,6-bis(4-azidobenzylidène)cyclohexanone, la 2,6-bis(4-azidobenzylidène)-4-méthylcyclohexanone, le 4,4-diazidobiphényle, le 4,4'-diazido-3,3'-diméthylbiphényle, ou le 2,7-diazidofluorène.

10. Composition suivant l'une quelconque des revendications précédentes, dans laquelle la proportion de doubles liaisons résiduelles dans le produit cyclisé est de 5 à 95%.

11. Composition suivant la revendication 10, dans laquelle la proportion de doubles liaisons résiduelles est de 15 à 50%.

12. Composition suivant l'une quelconque des revendications précédentes, dans laquelle le produit cyclisé est un produit cyclisé d'un homopolymère d'isoprène ou d'un homopolymère de butadiène.

13. Composition suivant l'une quelconque des revendications précédentes, dans laquelle l'agent de photo-réticulation est utilisé dans une proportion de 0,1 à 10 parties en poids pour 100 parties en poids de produit cyclisé.

14. Composition suivant la revendication 13, dans laquelle l'agent de photo-réticulation est utilisé dans une proportion de 1 à 5 parties en poids pour 100 parties en poids de produit cyclisé.

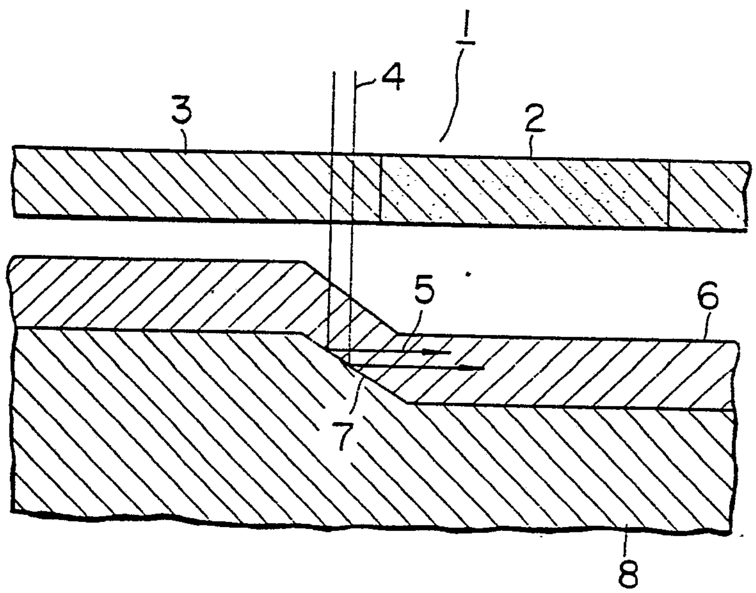
1
4
3
2
5
6
7
8